# EUROPEAN PATENT APPLICATION

(11) **EP 4 507 000 A1**
(43) Date of publication of application: **12.02.2025**
(21) Application number: 23306350.2
(22) Date of filing: 08.08.2023
(51) Int. Cl.: H01L 27/02, H01L 29/735, H01L 29/08

(54) **AN ELECTROSTATIC DISCHARGE PROTECTION DEVICE AND A METHOD**

(71) Applicant: NXP USA, Inc., Austin TX 78735 (US)
(72) Inventor: Laine, Jean-Philippe, 31023 Toulouse (FR); Bresse, Patrice, 31023 Toulouse (FR); Zhang, Zhihong, 5656 AG Eindhoven (NL)
(74) Representative: Schmütz, Christian Klaus Johannes

(57) **Abstract**

A semiconductor device comprising an electrostatic discharge, ESD, protection device, the ESD protection device comprising a first PNP cell comprising: a substrate comprising a n-doped buried layer, NBL, extending laterally at a surface of the substrate, wherein the NBL comprises a first NBL portion, a second NBL portion and a third NBL portion laterally arranged at the surface of the substrate with the second NBL portion positioned between the first NBL portion and the third NBL portion, wherein the second NBL portion has a second n-doping level that is less than a first n-doping level of the first NBL portion and less than a third n-doping level of the third NBL portion; an epitaxial layer arranged on the surface of the substrate and comprising a PNP device comprising: a first p-doped region; a second p-doped region; and a n-doped region positioned between the first p-doped region and the second p-doped region, wherein the first p-doped region is aligned with the second NBL portion.

## Description

### Field

The present disclosure relates to an electrostatic discharge (ESD) protection device and a method of manufacturing the same.

### Background

Integrated circuits manufactured on semiconductor devices can be damaged when electrostatic discharge (ESD) events are received from other circuits coupled to the semiconductor device or from people and/or machinery and tools touching the semiconductor device. During an ESD event the integrated circuit may receive a charge which leads to relatively large voltages during a relatively short period of time. If, for example, the integrated circuit breaks down as the result of the high voltage and starts to conduct the charge of the ESD event, a current of several amperes may flow through the integrated circuit during a relatively short period of time. These currents may cause irreparable damage to the integrated circuit.

### Summary

According to a first aspect of the present disclosure there is provided a semiconductor device comprising an electrostatic discharge, ESD, protection device, the ESD protection device comprising a first PNP cell comprising:
a substrate comprising a n-doped buried layer, NBL, extending laterally at a surface of the substrate, wherein the NBL comprises a first NBL portion, a second NBL portion and a third NBL portion laterally arranged at the surface of the substrate with the second NBL portion positioned between the first NBL portion and the third NBL portion, wherein the second NBL portion has a second n-doping level that is less than a first n-doping level of the first NBL portion and less than a third n-doping level of the third NBL portion;
an epitaxial layer arranged on the surface of the substrate and comprising a PNP device comprising:
   a first p-doped region;
   a second p-doped region; and
   a n-doped region positioned between the first p-doped region and the second p-doped region,
wherein the first p-doped region is aligned with the second NBL portion.

Aligning the first p-doped region with the lower doped second NBL portion can advantageously increase the breakdown voltage of the ESD protection device relative to a similar device with a uniformly doped NBL having the second n-doping level, without requiring additional die area or an increase in resistance.

In one or more embodiments, the first p-doped region is aligned with the second NBL portion in a vertical direction that is perpendicular to the surface of the substrate. In one or more embodiments, the first p-doped region is positioned above the second NBL portion. In one or more embodiments, a plane of the surface of the substrate defines a lateral plane. In one or more embodiments, a normal to a plane of the surface of the substrate defines a vertical direction.

In one or more embodiments, the first n-doping level of the NBL equals the third n-doping level of the NBL.

In one or more embodiments, a top surface of the first p-doped region comprises an active opening for a first electrical contact and the active opening of the first p-doped region is aligned with the second NBL portion.

In one or more embodiments, the active opening of the first p-doped region is aligned with the second NBL portion in the vertical direction. In one or more embodiments, the active opening of the first p-doped region is positioned above the second NBL portion in the vertical direction.

In one or more embodiments, a top surface of the first p-doped region comprises:
an active opening for a first electrical contact
a first shallow trench isolation, STI, region on a first side of the active opening; and
a second STI region on a second side of the active opening, wherein:
   at least a portion of the first STI region of the first p-doped region is aligned with the first NBL portion; and
   at least a portion of the second STI region of the first p-doped region is aligned with the third NBL portion.

In one or more embodiments, at least a portion of the first STI region of the first p-doped region is positioned above / aligned with the first NBL portion in the vertical direction. In one or more embodiments, at least a portion of the second STI region of the first p-doped region is positioned above / aligned with the third NBL portion in the vertical direction.

In one or more embodiments, a lateral extent of the second NBL portion lies within a lateral extent of the active opening.

In one or more embodiments, a distance from a first lateral edge of the first p-doped region to a respective first lateral edge of the active opening is greater than a distance from the first lateral edge of the first p-doped region to a respective first lateral edge of the second NBL portion. In one or more embodiments, a distance from a second lateral edge of the first p-doped region to a respective second lateral edge of the active opening is greater than a distance from the second lateral edge of the first p-doped region to a respective second lateral edge of the second NBL portion.

In one or more embodiments, the epitaxial layer comprises a p-doped epitaxial layer with a bulk doping level and the first p-doped region, second p-doped region and n-doped region are arranged within the p-doped epitaxial layer. In one or more embodiments, the first p-doped region is a high-voltage p-doped region with a first p-doping level higher than the bulk doping level, and the second p-doped region is a high-voltage p-doped region with a second p-doping level higher than the bulk doping level.

In one or more embodiments, the n-doped region comprises a deep n-doped pillar extending from a top surface of the epitaxial layer to the NBL.

In one or more embodiments, the PNP device comprises a PNP transistor, wherein the first p-doped region comprises a collector of the PNP transistor, the second p-doped region comprises an emitter of the PNP transistor and the n-doped region comprises a base of the PNP transistor.

In one or more embodiments, the second p-doped region is for connecting to an IO terminal. In one or more embodiments, the first p-doped region is for connecting to a negative terminal.

In one or more embodiments, the ESD protection device comprises a second PNP cell arranged in parallel with the first PNP cell to form a first PNP cell pair, wherein the second PNP cell comprise the same structure as the first PNP cell.

In one or more embodiments, the ESD protection device comprises a second PNP cell pair stacked in series with the first PNP cell pair, wherein the second PNP cell pair comprises a third PNP cell and a fourth PNP cell arranged in parallel with the third PNP cell.

In one or more embodiments, the third PNP cell and the fourth PNP cell each comprise:
a further substrate comprising a further n-doped buried layer, NBL, extending laterally at a surface of the substrate, wherein the further NBL comprises the first n-doping level; and
a further epitaxial layer arranged on the surface of the further substrate and comprising a further PNP device comprising:
   a further first p-doped region;
   a further second p-doped region; and
   a further n-doped region positioned between the further first p-doped region and the further second p-doped region.

In one or more embodiments, the third PNP cell and the fourth PNP cell comprise the same structure as the first PNP cell.

According to a second aspect of the present disclosure, there is provide a method of manufacturing a semiconductor device comprising an electrostatic discharge, ESD, protection device, the method comprising:
manufacturing a n-doped buried layer, NBL, in a substrate, the NBL extending laterally at a surface of the substrate, wherein the NBL comprises a first NBL portion, a second NBL portion and a third NBL portion laterally arranged at the surface of the substrate with the second NBL portion positioned between the first NBL portion and the third NBL portion, wherein the second NBL portion has a second n-doping level that is less than a first n-doping level of the first NBL portion and less than a third n-doping level of the third NBL portion; and
providing an epitaxial layer on the surface of the substrate, the epitaxial layer comprising a PNP device comprising:
   a first p-doped region;
   a second p-doped region; and
   a n-doped region positioned between the first p-doped region and the second p-doped region,
wherein providing the epitaxial layer comprises aligning the first p-doped region with the second NBL portion

In one or more embodiments, manufacturing the NBL comprises:
implanting n-doped material in the substrate to provide a NBL with the second n-doping level;
masking a portion of the surface of the substrate to mask the second NBL portion and expose the first and third NBL portions; and
implanting n-doped material in the first and third NBL portions to provide the first and third NBL portions with the first doping level.

In one or more embodiments, providing the epitaxial layer may comprise providing an active opening for a first electrical contact in a top surface of the first p-doped region, and aligning the active opening with the second NBL portion.

Aligning the active opening with the second NBL portion may comprise aligning the active opening with the second NBL portion such that a lateral extent of the second NBL portion lies within a lateral extent of the active opening.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 illustrates a simplified example ESD protection device;
Figure 2 illustrates an example ESD protection device for a battery management system;
Figure 3 illustrates an example ESD protection device with a 100V breakdown voltage;
Figure 4 illustrates an example ESD protection device according to an embodiment of the present disclosure;
Figure 5 illustrates an example ESD protection device for a battery management system according to an embodiment of the present disclosure;
Figure 6A illustrates transmission line pulse (TLP) measurements for three candidate 100V ESD protection devices;
Figure 6B illustrates the variation in breakdown voltage based on the a spacing parameter; and
Figure 7 illustrates a method of manufacturing an ESD protection device according to an embodiment of the present disclosure.

### Detailed Description

Semiconductor circuits can comprise integrated ESD protection to protect integrated circuits from ESD events. ESD protection devices may comprise a PNP structure arranged in an epitaxial layer above a n buried layer (NBL). The ESD protection device can provide protection from ESD events up to a breakdown voltage (BV).

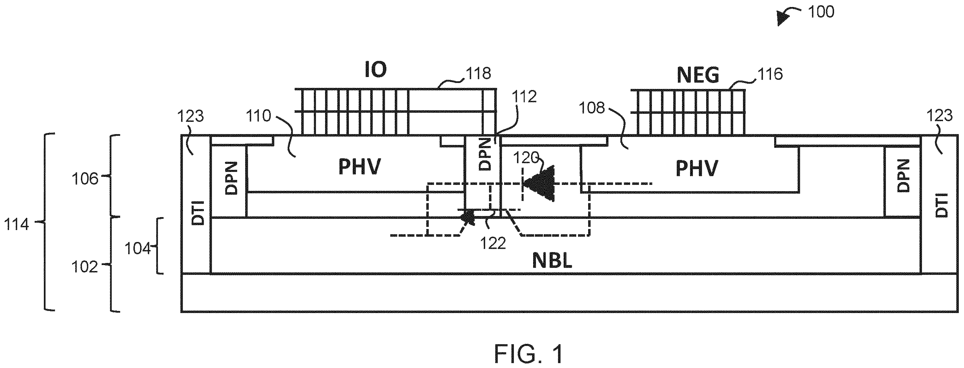

Figure 1 illustrates a simplified example ESD protection device 100 comprising a PNP structure arranged above a NBL.

The ESD protection device 100 comprises a substrate 102. The substrate 102 may comprise a p-doped substrate and be lightly doped with p-type material. A n-buried layer (NBL) 104 is manufactured in the substrate 102, for example by masking and ion implantation. The NBL 104 comprises a relatively large amount of n-type material. The NBL 104 forms a layer within the substrate 102 that extends laterally at a surface of the substrate 102 and vertically from the surface of the substrate 102 to a NBL depth. The substrate 102 may include a buried oxide layer underlying the NBL 104.

The ESD protection device 100 further comprises an epitaxial layer 106 manufactured on the surface of the substrate 102. The epitaxial layer 106 includes a PNP structure comprising: a first p-doped region 108; a second p-doped region 110; and a n-doped region 112 positioned between the first p-doped region 108 and the second p-doped region 110. The first and second p-doped regions 108, 110 are high-voltage p-doped region (labelled PHV). The n-doped region 112 is a deep n-doped region (labelled DPN) and extends through the epitaxial layer 106 from a top surface of the epitaxial layer 106 to the NBL 104.

The substrate 102 and the epitaxial layer 106 together form a semiconductor substrate 114 upon which an integrated circuit can be defined. The first p-doped region 108 comprises a contact region for providing a first terminal for a first contact 116 (labelled NEG) of the integrated circuit. The first terminal is configured to be connected to a negative voltage or ground. The second p-doped region 110 comprises a contact region for providing a second terminal for a second contact 118 (labelled IO) of the integrated circuit. The second terminal is configured to be electrically coupled to a structure of the IC which is susceptible to ESD events for example, an I/O pad of the semiconductor device.

The n-doped region 112 is positioned adjacent to (in contact with) the second p-doped region 110 and is laterally spaced apart from the first p-doped region 108. Providing a spacing between the first p-doped region 108 and the n-doped region 112 increases the BV for a diode 120 formed between the two regions.

The first p-doped region 108, the second p-doped region 110 and the n-doped region 112 form a PNP bipolar transistor 122, with the first p-doped region 108 forming the collector, the second-p-doped region forming the emitter and the n-doped region 112 forming the base.

In this example, deep trench isolation (DTI) structures 123 separate the ESD protection device 100 from neighbouring ESD protection devices on the same substrate 102.

As an example operation of the ESD protection device, during a positive voltage ESD event at the second contact 118, the diode 120 becomes reverse biased. Once the voltage across the diode 120 exceeds the breakdown voltage of the diode, current flows from the second contact 118 through the second p-doped region 110, to the n-doped region 112 and to the first p-doped region 108. This current switches on the transistor 122 which can safely conduct the ESD event from the second contact 118 to the first contact 116 such that the ESD event does not flow through and irreparably damage the integrated circuit. An activation voltage of the ESD protection circuit 100 can be defined by the spacing between the first p-doped region 108 and the n-doped region 112 which defines the BV of the diode 120.

A breakdown voltage of the transistor 122 between the base and the collector defines the maximum voltage or breakdown voltage of the ESD protection circuit 100. This breakdown voltage is set by the vertical structure below the first contact 116, i.e the vertical structure from the first p-doped region 108 to the NBL 104. This PHV/NBL structure defines the breakdown voltage of the transistor 122.

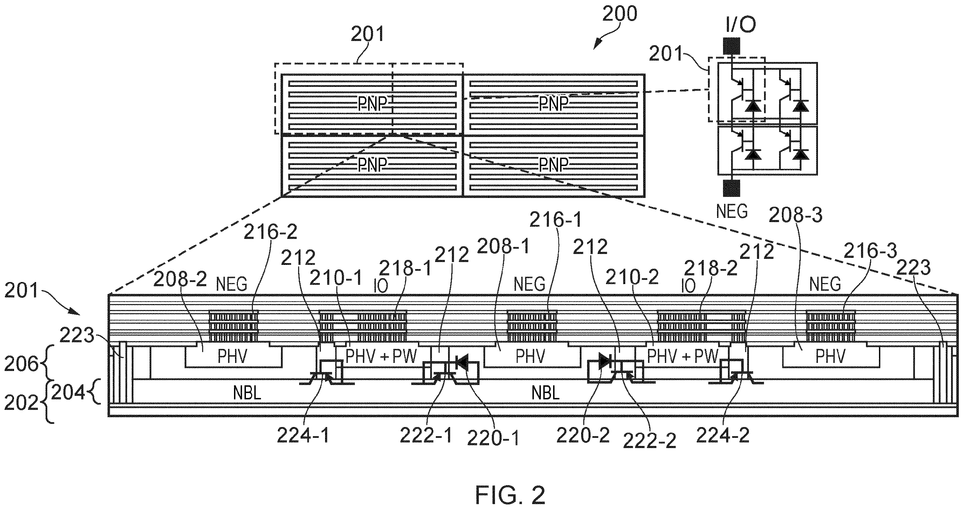

Figure 1 illustrates a simplified example of an ESD protection device. Some applications have a high BV requirement for the integrated ESD protection device. In some examples, an ESD protection device can comprise multiple PNP structures to provide a higher breakdown voltage. There are multiple known ways of arranging one or more PNP structures including coupling to NPN structures and/or silicon controlled rectifiers (SCR). Figure 2 illustrates an example ESD protection device comprising multiple HV-PNP cells, each HV-PNP cell comprising multiple PNP structures in the epitaxial layer 206. Features of Figure 2 that are present in Figure 1 have been given corresponding numbers in the 200 series and will not necessarily be described again here.

In this example, an ESD protection device 200 comprises four HV-PNP cells 201, with two parallel HV-PNP cells 201 stacked in series with another two parallel HV-PNP cells 201.

In this example, the epitaxial layer 206 of each HV-PNP cell 201 includes: three isolated first p-doped regions 208-1, 208-2, 208-3 (labelled *PHV*) coupled to negative first contacts 216-1, 216-2, 216-3 (labelled *NEG*); two second p-doped regions 216-1, 216-2 (labelled *PHV*+*PW* (p-well)) coupled to IO second contacts 218-1, 218-2 (labelled IO); and n-doped regions 212 comprising DPN either side of, and contacting, the second p-doped regions 210-1, 210-2. The PNP arrangements of each HV-PNP cell form: two internal diodes 222-1, 222-2 (between the central first p-doped region 208-1 and the n-doped regions 212 contacting the adjacent second p-doped regions 210-1, 210-2); two internal PNP transistors 222-1, 222-2 with floating base DPN (between the central first p-doped region 208-1, the two adjacent second p-doped regions 210-1, 210-2 the intervening n-doped regions 212 and the NBL 204); and two internal PNP transistors 224-1, 224-2 with contacted base DPN (between second p-doped regions 210-1, 210-2, NBL 204 and n-doped regions 212 on outer sides of the second p-doped regions 210-1, 210-2), as illustrated. Each HV-PNP cell 201 has a simplified representation in the circuit diagram as a PNP transistor with a diode coupling the collector and base.

The ESD protection device 200 including four HV-PNP cells 201 can provide a ESD breakdown voltage of ~95V and may be used in automotive battery management systems (BMS). However, new application requirements for BMSs can require >100V protection and a clamping voltage should start at around 110 V.

One option for increasing the breakdown voltage of the ESD protection circuit 200A of Figure 2 is to reduce the doping of the NBL 204. However, decreasing the doping results in an undesirable increase in resistance making such a solution ineffective.

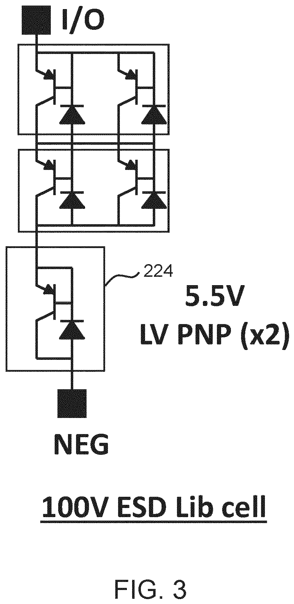

Figure 3 illustrates a further option for an ESD protection device 300 with an increased breakdown voltage. In this example, a further low voltage (e.g. 5.5V) PNP structure 326 is stacked in series with the four HV-PNP cell arrangement of Figure 2. A drawback in this approach is an increase in effective area of the ESD protection device 300 by 18% relative to the device 200 of Figure 2.

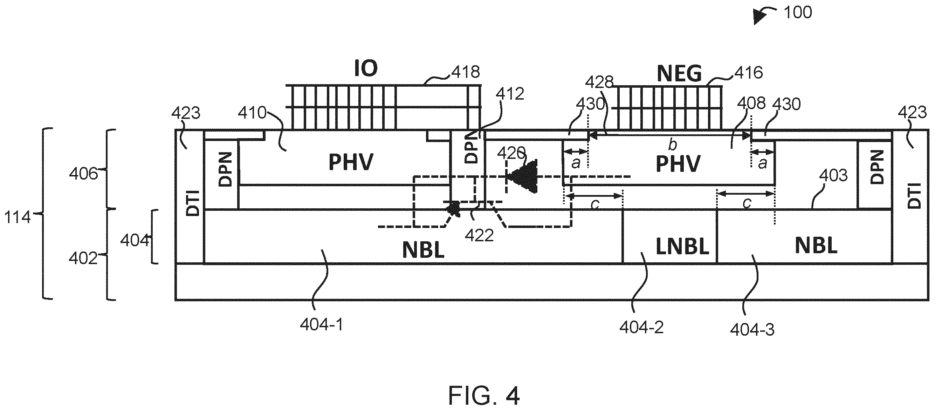

Figure 4 illustrates a cross-section of an ESD protection device 400 according to an embodiment of the present disclosure. The ESD protection device 400 can have an increased BV relative to the corresponding device of Figure 1. Features of Figure 4 that are present in Figures 1 and 2 have been given corresponding numbers in the 400 series and will not necessarily be described again here.

The ESD protection device 400 includes a substrate 402 comprising a NBL 404. The NBL 404 extends laterally at a surface 403 of the substrate 402. The NBL 404 comprises a first NBL portion 404-1 (labelled *NBL*), a second NBL portion 404-2 (labelled *LNBL* (light NBL)) and a third NBL portion 404-3 (labelled *NBL*) laterally arranged at the surface 403 of the substrate 402, with the second NBL portion 404-2 positioned between the first NBL portion 404-1 and the third NBL portion 404-3. The second NBL portion 404-2 has a second n-doping level that is less than both: (i) a first n-doping level of the first NBL-portion 404-1; and (ii) a third n-doping level of the third NBL portion 404-3. The first n-doping level and the third n-doping level may be the same.

The ESD protection device 400 further includes an epitaxial layer 406 arranged on the surface 403 of the substrate comprising a PNP device. The PNP device (or PNP structure) comprises: a first doped p-region 408; a second doped p-region 410; and a n-doped region 412 positioned between the first and second p-doped regions 408, 410. The first p-doped region 408 is positioned above (i.e. vertically aligned with) the second NBL portion 404-2.

As described herein, the terms lateral, extending laterally etc refers to a lateral plane which is a plane parallel to the plane of the surface 403 of the substrate 402. As described herein, the term vertical and the corresponding references to above or below, correspond to a vertical direction / axis parallel to a normal to the surface 403 of the substrate 402.

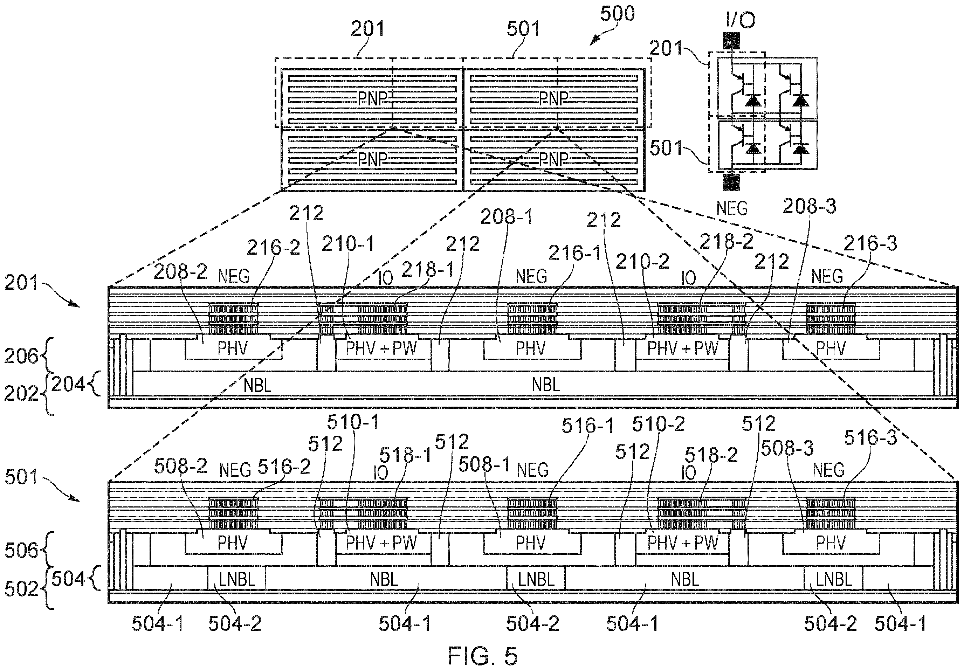

By positioning the first p-doped region 408 (collector) vertically in line with the lower doped second NBL portion 404-2, the ESD protection device 400 has a higher BV than the corresponding structure of Figure 1. The general concept of providing lighter doped NBL portions 404-2 below the first p-doped regions 408 can be extended to any PNP structured ESD protection device, such as one or more of the HV-PNP cells of Figure 2. In this way, embodiments may provide an ESD protection device meeting the new 100V BMS requirements (see Figure 5) without requiring an increase in die area or an increase in device resistance.

The NBL 404 may be formed by masking and implantation. The implantation may be performed in two steps with a first step providing a doping of the second n-doping level for all of the NBL 404. In the second step, the second NBL portion may be masked during further implantation to increase the doping level in the first and third NBL portions. A buried oxide layer (not shown) may be formed underlying the NBL 404.

The first and second p-doped regions 408, 410 are high-voltage p-doped region (labelled PHV). The n-doped region 412 is a deep n-doped region (Labelled DPN) and extends through the epitaxial layer 406 from a top surface of the epitaxial layer 406 to the NBL 404.

The substrate 402 and the epitaxial layer 406 together form a semiconductor substrate 414 upon which an integrated circuit can be defined. The epitaxial layer 406 may comprise a p-doped epitaxial layer comprising a bulk doping level. The p-doped epitaxial layer 406 can be formed on the substrate 402 with the first and second p-doped regions 408, 410 and the n-doped region 412 then formed in the p-doped epitaxial layer 406 by sequential implantation and masking.

The first p-doped region 408 comprises a contact region for providing a first terminal for a first contact 416 (labelled NEG) of the integrated circuit. The first terminal is configured to be connected to a negative voltage or ground. The second p-doped region 410 comprises a contact region for providing a second terminal for a second contact 418 (labelled IO) of the integrated circuit. The second terminal is configured to configured to be electrically coupled to a structure of the IC which is susceptible to ESD events for example, an I/O pad of the semiconductor device.

The n-doped region 412 is positioned adjacent to the second p-doped region 410 and is laterally spaced apart from the first p-doped region 408. Providing a spacing between the first p-doped region 408 and the n-doped region 412 increases the BV for a diode 420 formed between the two regions.

The first p-doped region 408, the second p-doped region 410 and the n-doped region 412 form a PNP bipolar transistor 422, with the first p-doped region 408 forming the collector, the second-p-doped region 410 forming the emitter and the n-doped region 412 forming the base.

A top surface of the first p-doped region 408 includes an active opening 428 to enable coupling of the first p-doped region 408 to the first contact 416. The active opening 428 of the first p-doped region 408 may be positioned over the second NBL portion 404-2. In some examples, the lateral extent of the second NBL portion 404-2 may be within (vertically aligned within) the lateral extent of the active opening 428.

The top surface of the first p-doped region 408 may comprise shallow trench isolation (STI) regions 430 either side of the active opening 428. The STI regions 430 may have overlying oxide. At least a portion of the STI region 430 may be positioned above at least a portion of the first NBL portion 404-1 and at least a portion of the STI region 430 may be positioned above at least a portion of the third NBL portion 404-3.

The oxide overlying the STI regions 430 results in shallower implantation in a portion of the first p-doped region 408 under the STI regions 430 relative to a portion of the first p-doped region 408 under the active opening 428. In other words, the first p-doped region 408 is deepest and gets closest to the NBL 404 under the active opening 428. Therefore, positioning the active opening 428 over the lower doped second NBL portion 402-2 advantageously optimises the position of the second NBL portion 404-2 for increasing the BV of the ESD device 400. Limiting the lateral extent of the second NBL portion 404-2 to only lie within the lateral extent of the active opening 428 limits the size of the second NBL portion 404-2 and the resulting increase in resistance of the device 400.

One or more spacing parameters may be used to define the lateral extent of the second NBL portion 404-2 with respect to the lateral extent of the active opening 428. A first parameter, *a*, may define a distance from a lateral edge of the first p-doped region 408 to a lateral edge of the active opening 428. In other words, the first parameter a defines the portion of the first p-doped region 408 under the STI 430. A second parameter, *b*, may define the lateral extent (or width) of the active opening 428. A third parameter, *c,* may define a distance from a lateral edge of the first p-doped region 408 to a lateral edge of the second NBL portion 402-2. In some examples, the third parameter, c, may be greater than the first parameter, *a*. In other words: (i) a distance from a first lateral edge of the first p-doped region 408 to a respective (same side) first lateral edge of the active opening 428 is greater than a distance from the first lateral edge of the first p-doped region 408 to a respective first lateral edge (same side) of the second NBL portion 404-2; and (ii) a distance from a second lateral edge of the first p-doped region 408 to a respective second lateral edge (same side) of the active opening 428 is greater than a distance from the second lateral edge of the first p-doped region 408 to a respective second lateral edge of the second NBL portion 404-2. Put another way, the lateral extent of the second NBL portion 404-2 is less than the second parameter, *b*, and lies within the lateral extent of the active opening 428.

As noted above, the general concept of providing lower doped NBL portions 404-2 below the first p-doped regions 408 can be extended to any PNP structured ESD protection device. Figure 5 illustrates an example ESD protection device 500 comprising multiple HV-PNP cells 201, 501 according to an embodiment of the disclosure. The ESD protection device 500 can advantageously meet the 100V automotive BMS application requirement.

In this example, the ESD protection device 500 comprises two NBL HV-PNP cells 201 arranged in parallel, each cell 201 having the same uniformly doped NBL structure as those of Figure 2. The numbering of Figure 2 has been maintained to highlight these NBL HV-PNP cells 201. The ESD protection device 500 further comprises two NBL/LNBL HV-PNP cells 501 with a NBL 504 having different portions 504-1, 504-2 with different doping. The two NBL HV-PNP cells 201 are stacked in series with the two NBL/LNBL HV-PNP cells 501 to provide a ESD protection circuit 500 meeting the 100V requirement. Other example ESD protection devices may include four NBL/LNBL HV-PNP cells 501 to provide a yet higher BV, albeit with a higher resistance.

In this example, the NBL/LNBL HV-PNP cell 501 is the same as the NBL HV-PNP cell 201 other than the NBL 504 of the NBL/LNBL HV-PNP cell 501 includes first NBL portions 504-1 with a first n-doping level and second NBL portions 504-2 with a second n-doping level, wherein the second n-doping level is less than the first n-doping level. The epitaxial layer 506 comprises three first p-doped regions 508-1, 508-2, 508-3 each arranged above a corresponding second NBL portion 504-2. In particular, an active opening of each first p-doped region 508-1, 508-2, 508-3 is arranged above the corresponding second NBL portion 504-2. A lateral extent of the second NBL portion 504-2 lies within a lateral extent of the respective active opening of the first p-doped region 508. Second p-doped regions 510-1, 510-2 and are both arranged above respective first NBL portions 504-1. The n-doped regions 512 are also arranged above first NBL portions 504-1.

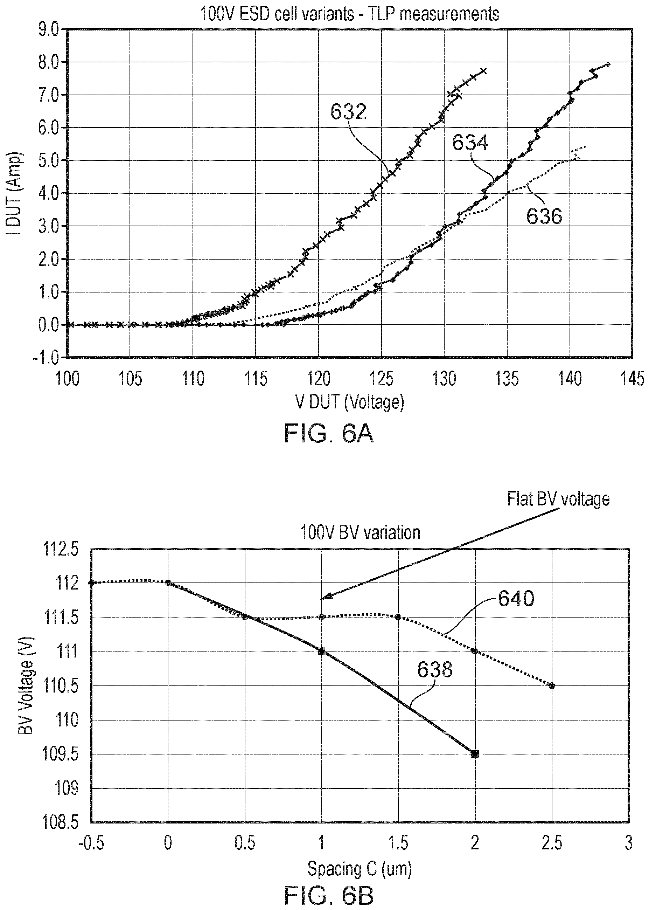

Figure 6A shows transmission line pulse (TLP) measurements for three ESD protection devices. TLP measurements allow assessment of device performance in the absence of destructive thermal effects that would occur at DC current. A first curve 632 illustrates the current-voltage (IV) performance of a first 95V ESD protection device based on the four HV-PNP cell structure of Figure 2 with a uniformly doped NBL. The NBL has a high doping to decrease the BV but this results in a low resistance as can be seen by the steeper slope of the first curve 632. The breakdown voltage is limited to 95V because of the higher doping. A second curve 634 illustrates the IV performance of a second 100V ESD protection device based on the structure of Figure 3 with an additional low voltage HV-PNP cell. The resistance is similar to the first curve 632 but a significant increase in area is required. The third curve 636 illustrates the IV performance of the 100V ESD protection device of Figure 5. The resistance is only marginally higher than the other two devices and acceptable for IC protection applications. Crucially, the BV is increased to 100V without modifying the size and without a significant increase in resistance relative to the first ESD protection of Figure 2.

Figure 6B illustrates the variation in breakdown voltage based on the third spacing parameter, c, defined above. A first plot 638 illustrates the variation of the BV (measured in V) against the value of the third spacing parameter, c, (in microns) for a value of the first spacing parameter, a, equal to 1 um. The first plot illustrates the general trend that a higher BV can be obtained when the third spacing parameter, c, is less than the first spacing parameter, a.

A second plot 640 illustrates the variation of the BV (measured in V) against the value of the third spacing parameter, c, (in microns) for a value of the first spacing parameter, a, equal to 2 um. The second plot 640 includes a plateau where the BV remains substantially constant as the third parameter spacing varies between 0.5-1.5 um. Such a plateau can advantageously provide a fixed BV while allowing for an error in overlay mask alignment when defining the NBL portions or the first p-doped regions. In some examples, the first parameter spacing, a, may be 2 um and the third parameter spacing may be 1 um, to realise a +/- 0.44 um error allowance in mask alignment.

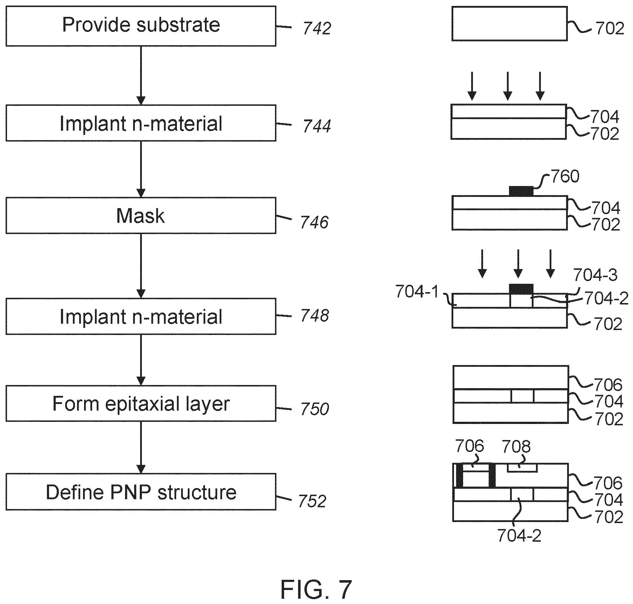

Figure 7 illustrates a method of manufacturing an ESD protection device according to an embodiment of the present disclosure. The Figure includes schematics of the structure after different steps of manufacture.

A first step 742 comprises providing a substrate 702. The substrate may comprise a p-doped substrate and may comprise a silicon-on-insulator substrate.

A second step 744 comprises implanting n-doping material to form a NBL 704 at a surface of the substrate 702. The NBL extends laterally across the surface of the substrate 702. Following implantation, the NBL comprises a second n-doping level.

A third step 746 comprises masking the surface of the substrate using lithography. The mask 760 (e.g. photoresist) masks a second NBL portion 704-2 and exposes first and third NBL portions 704-1, 704-3.

A fourth step 748 comprises implanting further n-doping material to increase the n-doping level in the first and third NBL portions 704-1, 704-3. The resulting NBL comprises: a first NBL portion 704-1 with a first n-doping level; a second NBL portion 704-2 with a second n-doping level less than the first n-doping level; and a third NBL portion 704-3 with the first n-doping level.

After removal of the mask, a fifth step 750 comprises forming an epitaxial layer 706 on the surface of the substrate 702, e.g. by a known material deposition technique. The epitaxial layer may comprise a p-doped epitaxial layer with a bulk doping level.

A sixth step 752 comprises defining a PNP structure in the epitaxial layer 706. The PNP structure comprises a first p-doped region 708, a second p-doped region 710 and an n-doped region 712. The first p-doped region 708 is aligned with the second NBL portion 704-2. The first and second p-doped regions may be formed by masking and implantation of p-doping material. The n-doped region may be formed by masking and implantation of n-doping material. Further steps may comprise defining STI and DTI features, contacts and insulation.

Throughout the present specification, the descriptors relating to relative orientation and position, such as "horizontal", "vertical", "top", "bottom," "lateral," "vertical," "above," "below," "lateral edge," and "side", are used in the sense of the orientation of the ESD protection device as presented in the drawings. However, such descriptors are not intended to be in any way limiting to an intended use of the described or claimed invention.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A semiconductor device comprising an electrostatic discharge, ESD, protection device, the ESD protection device comprising a first PNP cell comprising:
a substrate comprising a n-doped buried layer, NBL, extending laterally at a surface of the substrate, wherein the NBL comprises a first NBL portion, a second NBL portion and a third NBL portion laterally arranged at the surface of the substrate with the second NBL portion positioned between the first NBL portion and the third NBL portion, wherein the second NBL portion has a second n-doping level that is less than a first n-doping level of the first NBL portion and less than a third n-doping level of the third NBL portion;
an epitaxial layer arranged on the surface of the substrate and comprising a PNP device comprising:
a first p-doped region;
a second p-doped region; and
a n-doped region positioned between the first p-doped region and the second p-doped region,
wherein the first p-doped region is aligned with the second NBL portion.

2. The semiconductor device of claim 1, wherein a top surface of the first p-doped region comprises an active opening for a first electrical contact and wherein the active opening of the first p-doped region is aligned with the second NBL portion.

3. The semiconductor device of claim 1 or claim 2, wherein a top surface of the first p-doped region comprises:
an active opening for a first electrical contact
a first shallow trench isolation, STI, region on a first side of the active opening; and
a second STI region on a second side of the active opening, wherein:
at least a portion of the first STI region of the first p-doped region is aligned with the first NBL portion; and
at least a portion of the second STI region of the first p-doped region is aligned with the third NBL portion.

4. The semiconductor device of claim 2 or claim 3, wherein a lateral extent of the second NBL portion lies within a lateral extent of the active opening.

5. The semiconductor device of any of claims 2 to 4, wherein:
a distance from a first lateral edge of the first p-doped region to a respective first lateral edge of the active opening is greater than a distance from the first lateral edge of the first p-doped region to a respective first lateral edge of the second NBL portion; and
a distance from a second lateral edge of the first p-doped region to a respective second lateral edge of the active opening is greater than a distance from the second lateral edge of the first p-doped region to a respective second lateral edge of the second NBL portion.

6. The semiconductor device of any preceding claim, wherein the epitaxial layer comprises a p-doped epitaxial layer with a bulk doping level and wherein the first p-doped region, second p-doped region and n-doped region are arranged within the p-doped epitaxial layer, wherein the first p-doped region is a high-voltage p-doped region with a first p-doping level higher than the bulk doping level and the second p-doped region is a high-voltage p-doped region with a second p-doping level higher than the bulk doping level.

7. The semiconductor device of any preceding claim, wherein the n-doped region comprises a deep n-doped pillar extending from a top surface of the epitaxial layer to the NBL.

8. The semiconductor device of any preceding claim, wherein the PNP device comprises a PNP transistor, wherein the first p-doped region comprises a collector of the PNP transistor, the second p-doped region comprises an emitter of the PNP transistor and the n-doped region comprises a base of the PNP transistor.

9. The semiconductor device of any preceding claim, wherein:
the second p-doped region is for connecting to an IO terminal; and
the first p-doped region is for connecting to a negative terminal.

10. The semiconductor device of any preceding claim, wherein the ESD protection device comprises a second PNP cell arranged in parallel with the first PNP cell to form a first PNP cell pair, wherein the second PNP cell comprise the same structure as the first PNP cell.

11. The semiconductor device of claim 10, wherein the ESD protection device comprises a second PNP cell pair stacked in series with the first PNP cell pair, wherein the second PNP cell pair comprises a third PNP cell and a fourth PNP cell arranged in parallel with the third PNP cell.

12. The semiconductor device of claim 11, wherein the third PNP cell and the fourth PNP cell each comprise:
a further substrate comprising a further n-doped buried layer, NBL, extending laterally at a surface of the substrate, wherein the further NBL comprises the first n-doping level; and
a further epitaxial layer arranged on the surface of the further substrate and comprising a further PNP device comprising:
a further first p-doped region;
a further second p-doped region; and
a further n-doped region positioned between the further first p-doped region and the further second p-doped region.

13. The semiconductor device of claim 11, wherein the third PNP cell and the fourth PNP cell comprise the same structure as the first PNP cell.

14. A method of manufacturing a semiconductor device comprising an electrostatic discharge, ESD, protection device, the method comprising:
manufacturing a n-doped buried layer, NBL, in a substrate, the NBL extending laterally at a surface of the substrate, wherein the NBL comprises a first NBL portion, a second NBL portion and a third NBL portion laterally arranged at the surface of the substrate with the second NBL portion positioned between the first NBL portion and the third NBL portion, wherein the second NBL portion has a second n-doping level that is less than a first n-doping level of the first NBL portion and less than a third n-doping level of the third NBL portion; and
providing an epitaxial layer on the surface of the substrate, the epitaxial layer comprising a PNP device comprising:
a first p-doped region;
a second p-doped region; and
a n-doped region positioned between the first p-doped region and the second p-doped region,
wherein providing the epitaxial layer comprises aligning the first p-doped region with the second NBL portion

15. The method of claim 14, wherein manufacturing the NBL comprises:
implanting n-doped material in the substrate to provide a NBL with the second n-doping level;
masking a portion of the surface of the substrate to mask the second NBL portion and expose the first and third NBL portions; and
implanting n-doped material in the first and third NBL portions to provide the first and third NBL portions with the first doping level.
